# EUROPÄISCHE PATENTSCHRIFT

(11) **EP 1 704 599 B1**
(45) Veröffentlichungstag und Bekanntmachung des Hinweises auf die Patenterteilung: **31.10.2007**
(21) Anmeldenummer: 04803855.8
(22) Anmeldetag: 14.12.2004
(51) Int. Cl.: H01L 31/032, C30B 29/46

(54) **VERFAHREN ZUR BEHANDLUNG VON PULVERKÖRNERN**
METHOD FOR TREATING POWDER PARTICLES
PROCEDE POUR TRAITER DES PARTICULES DE POUDRE

(30) Priorität: 22.12.2003 EP 03029577
(43) Veröffentlichungstag der Anmeldung: 27.09.2006
(73) Patentinhaber: Scheuten Glasgroep, 5900 AA Venlo (NL)
(72) Erfinder: GEYER, Volker, 41372 Niederkrüchten (DE); KAUK, Marit, EE76902 Harku (EE); RAUDOJA, Jaan, Tallinn (EE); VAREMA, Tiit, EE11716 Tallinn (EE); ALTOSAAR, Mare, EE12917 Tallinn (EE)
(74) Vertreter: Jostarndt, Hans-Dieter
(86) Internationale Anmeldenummer: PCT/EP2004/014232
(87) Internationale Veröffentlichungsnummer: WO 2005/064691

(56) Entgegenhaltungen:
- WO-A-94/27328
- ALTOSAAR M ET AL: "Monograin layer solar cells" PREPARATION AND CHARACTERIZATION, ELSEVIER SEQUOIA, NL, Bd. 431-432, 1. Mai 2003 (2003-05-01), Seiten 466-469, XP004428688 ISSN: 0040-6090

## Beschreibung

Die Erfindung betrifft ein Verfahren zur Behandlung von Pulverkörnern.

Das Verfahren eignet sich insbesondere zur Behandlung von Pulverkörnern, die aus einer Cu(In,Ga)Se₂-Verbindung bestehen.

Diese Pulver eignen sich zur Herstellung von Monokornmembranen, die in Solarzellen eingesetzt werden. Solche Solarzellen sind aus Altosaar et al. in Thin Solid Films 431-432 (2003), Seite 466-469, bekannt.

Der Erfindung liegt die Aufgabe zugrunde, ein Verfahren zu schaffen, mit dem die Eigenschaften eines Cu(In,Ga)Se₂-Pulvers im Hinblick auf einen Einsatz dieses Pulvers in einer Solarzelle verbessert werden können.

Ferner ist Aufgabe der Erfindung eine Monokornmembran-Solarzelle bereitzustellen, die einen möglichst hohen Wirkungsgrad aufweist.

Bezüglich des Verfahrens wird diese Aufgabe erfindungsgemäß durch ein Verfahren zur Behandlung von aus einer Cu(In,Ga)Se₂-Verbindung bestehenden Pulverkörnern gelöst, bei denen die Pulverkörner und Schwefel in ein Gefäß hineingegeben werden und der aus den Pulverkörnern und dem Schwefel bestehende Inhalt des Gefäßes erhitzt und nach dem Erhitzen auf einer konstanten Temperatur gehalten wird.

Die Anwendung des erfindungsgemäßen Verfahrens führt zu der überraschenden Wirkung, dass Solarzellen, bei denen das anhand des Verfahrens behandelte Pulver eingesetzt wird, einen deutlich höheren Wirkungsgrad aufweisen, als Solarzellen, in denen ein Pulver eingesetzt wird, das nicht anhand des erfindungsgemäßen Verfahrens behandelt wurde.

Eine mögliche Erklärung für die deutliche Verbesserung der photovoltaischen Eigenschaften der Pulverkörner könnte wie folgt lauten:

Es besteht die Möglichkeit, dass in den aus der Cu(In,Ga)Se₂-Verbindung bestehenden Körnern Bereiche mit einem unterstöchiometrischen Se-Gehalt existieren. In diesen Bereichen kann es zu einer Abscheidung einer aus Cu, Ga oder In bestehenden Fremdphase von einer Phase aus stöchiometrischem Cu(In,Ga)Se₂ kommen, wobei die Fremdphasen sich bevorzugt an der Oberfläche der Pulverkörner anlagern.

Aufgrund des metallischen Charakters der Fremdphase kann es dann beispielsweise zu einem Kurzschluss im pn-Kontakt der Solarzelle kommen.

Bei dem erfindungsgemäßen Verfahren wurde eine Schwefelung durchgeführt, bei der vermutlich die auf der Oberfläche der Pulverkörner vorhandenen Fremdphasen in Cu(In,Ga)S₂ umgesetzt werden, eine Verbindung, die ebenfalls in Solarzellen Verwendung findet.

Diese Erklärung wird durch die Tatsache gestützt, dass bei Solarzellen, in denen anhand des erfindungsgemäßen Verfahrens behandelte Pulver eingesetzt wurden, eine deutlich erhöhte Leerlaufspannung gemessen wurde.

In einer bevorzugten Durchführungsform des Verfahrens werden die Pulverkörner in eine Zwei-Zonen-Ampulle gefüllt, wobei die Pulverkörner in eine der Zonen und der Schwefel in die andere Zone hineingegeben werden.

Die Pulverkörner werden dann vorzugsweise auf eine Temperatur zwischen 400°C und 600°C erhitzt.

Der Schwefel wird vorzugsweise auf eine Temperatur von etwa 100°C erhitzt.

Pulverkörner und Schwefel werden über einen Zeitraum zwischen einer Stunde und 50 Stunden auf der jeweiligen Temperatur gehalten.

In einer ebenfalls bevorzugten Durchführungsform des Verfahrens wird ein aus Pulverkörnern und Schwefel bestehendes Gemisch in eine Ampulle gefüllt.

Das Gemisch wird dann auf eine Temperatur zwischen 300°C und 600°C erhitzt und über einen Zeitraum zwischen 5 Minuten und 4 Stunden auf der Temperatur gehalten. Ein besonders vorteilhafter Temperaturbereich liegt dabei zwischen 380°C und 410°C.

Im Rahmen der Erfindung wird ebenfalls eine vorteilhafte Monokornmembran-Solarzelle geschaffen, die sich durch einen besonders hohen Wirkungsgrad im Vergleich zu anderen Monokornmembran-Solarzellen auszeichnet.

Die Solarzelle beinhaltet einen Rückkontakt, eine Monokornmembran, mindestens eine Halbleiterschicht und einen Frontkontakt und zeichnet sich dadurch aus, dass die Monokornmembran die erfindungsgemäß behandelten Pulverkörner enthält.

Diese Solarzelle weist aufgrund der vorteilhaften Eigenschaften der erfindungsgemäß behandelten Körner einen hohen Wirkungsgrad auf.

Die bevorzugten Durchführungsformen des erfindungsgemäßen Verfahrens werden nun detailliert erläutert:

In einer Durchführungsform des Verfahrens werden die aus einer Cu(In,Ga)Se₂-Verbindung bestehenden Pulverkörner und der Schwefel in eine sogenannte Zwei-Zonen-Ampulle gefüllt, wobei die Pulverkörner in die eine Zone und der Schwefel in die andere Zone der Zwei-Zonen-Ampulle eingegeben werden.

Eine Zwei-Zonen-Ampulle besteht aus einem beidseitig geschlossenen oder verschließbaren Röhrchen, das mittig eine Verjüngung aufweist. Die Form der Ampulle gleicht damit der einer Eieruhr. Die Zwei-Zonen-Ampulle wird bei dem Verfahren waagerecht liegend eingesetzt und sollte aus einem Material bestehen, das nicht mit den eingefüllten Stoffen reagiert. Sie besteht daher etwa aus Quarzglas.

Eine typische Füllmenge besteht aus 10 g Pulverkörnern und 2 g Schwefel.

Die Zwei-Zonen-Ampulle wird evakuiert, und der in der einen Zone befindliche Schwefel wird auf eine Temperatur um etwa 100°C erhitzt. Infolgedessen entsteht gasförmiges S₂, das sich in der gesamten Ampulle ausbreitet.

Die in der anderen Zone der Zwei-Zonen-Ampulle befindlichen Pulverkörner werden auf eine Temperatur zwischen 400°C und 600°C erhitzt.

Der Schwefeldampfdruck in der die Pulverkörner enthaltenen Zone der Ampulle lässt sich durch eine Veränderung der in dieser Zone herrschenden Temperatur variieren. Er sollte zwischen 0,13 Pa und 133 Pa liegen.

Pulverkörner und Schwefel werden nun über einen Zeitraum zwischen einer Stunde und 50 Stunden auf der jeweiligen Temperatur gehalten. In diesem Zeitraum werden, wie eingangs erläutert, vermutlich die evtl. auf der Oberfläche der Pulverkörner vorhandenen aus Cu, In und Ga bestehenden Fremdphasen in eine Cu(In,Ga)S₂-Verbindung umgesetzt.

Nach Ablauf der Zeit wird die Ampulle abgekühlt, und die geschwefelten Pulverkörner können entnommen werden.

Besonders gute Ergebnisse im Hinblick auf eine Verbesserung der photovoltaischen Eigenschaften der Pulverkörner konnten durch eine Behandlung erzielt werden, bei der die Pulverkörner auf 530°C und der Schwefel auf 107°C erhitzt wurden. Bei diesen Temperaturen ergab sich in der die Pulverkörner enthaltenden Zone der Zwei-Zonen-Ampulle ein Schwefeldampfdruck von 1,33 Pa. Die Behandlungszeit betrug 18 Stunden.

In einer anderen Durchführungsform des Verfahrens wird ein aus den Pulverkörnern und dem Schwefel bestehendes Gemisch in eine Ampulle gefüllt, die beispielsweise wiederum aus Quarzglas besteht. Ein typisches Gemisch besteht aus 50 Vol-% Pulver und 50 Vol-% Schwefel.

Die Ampulle wird evakuiert, und das Gemisch wird auf eine Temperatur zwischen 300°C und 600°C und vorzugsweise auf eine Temperatur zwischen 380°C und 410°C erhitzt. Bei dieser Temperatur ist der Schwefel flüssig und umgibt die Pulverkörner, die bei dieser Temperatur in der festen Phase vorliegen, gleichmäßig. Die Pulverkörner werden also gewissermaßen in dem flüssigen Schwefel "gekocht".

Bei dieser Durchführungsform beträgt der Zeitraum, in dem das Gemisch auf der nach dem Erhitzen erreichten Temperatur gehalten wird, zwischen 5 Minuten und 4 Stunden.

In diesem Zeitraum geschieht vermutlich wiederum die Umsetzung der evtl. auf der Oberfläche der Körner vorhandenen aus Cu, In und Ga bestehenden Fremdphasen in eine Cu(In, Ga)S₂-Verbindung.

Besonders gute Ergebnisse im Hinblick auf die photovoltaischen Eigenschaften der Körner konnten dabei durch eine 5-minütige Behandlung bei 410°C und eine anschließende 30-minütige Behandlung bei 380°C erzielt werden.

Anhand der Zeichnungen sollen nun einige Analysen präsentiert werden, welche für Solarzellen vorgenommen wurden, in denen aus einer CuInSe₂- Verbindung bestehende Pulver, welche anhand des erfindungsgemäßen Verfahrens behandelt wurde, eingesetzt wurden.

Von den Figuren zeigen
Fig. 1a ... eine Aufnahme eines ersten Pulverkorns mit eingezeichnetem Analysepfad,
Fig. 1b ... eine Grafik, welche die chemische Zusammensetzung des ersten Pulverkorns entlang des Analysepfades darstellt,
Fig. 2a ... eine Aufnahme eines zweiten Pulverkorns mit eingezeichnetem Analysepfad,
Fig. 2b ... eine Grafik, welche die chemische Zusammensetzung des zweiten Pulverkorns entlang des Analysepfads darstellt,
Fig. 3a ... eine Aufnahme eines dritten Pulverkorns mit eingezeichnetem Analysepfad,
Fig. 3b ... eine Grafik, welche die chemische Zusammensetzung eines dritten Pulverkorns mit eingezeichnetem Analysepfad darstellt,
Fig. 4a ... eine Aufnahme eines vierten Pulverkorns mit eingezeichnetem Analysepfad,
Fig. 4b ... eine Grafik, welche die chemische Zusammensetzung des vierten Pulverkorns entlang des Analysepfads darstellt,
Fig. 5a ... eine Aufnahme eines fünften Pulverkorns,
Fig. 5b ... eine Analyse des Se-Gehaltes des fünften Pulverkorns,
Fig. 5c ... eine Analyse des S- Gehaltes des fünften Pulverkorns,
Fig. 6 ... eine Aufnahme eines weiteren Pulverkorns,
Fig. 7 ... eine Aufnahme eines weiteren Pulverkorns,
Fig. 8 ... eine Aufnahme eines weiteren Pulverkorns,
Fig. 9 ... eine Aufnahme eines weiteren Pulverkorns,
Fig. 10 ... eine Aufnahme eines weiteren Pulverkorns,
Fig. 11 ... eine Grafik, welche den Wert einiger Kenngrößen einer Solarzelle in Anhängigkeit von der Behandlungstemperatur zeigt und
Fig. 12 ... eine Grafik, welche den Wert einiger Kenngrößen einer Solarzelle in Abhängigkeit der Behandlungsdauer zeigt.

Die Analyse wurde mit Pulverkörnern durchgeführt, welche vor der Behandlung aus einer CuInSe₂- Verbindung bestanden und somit kein Ga enthielten.

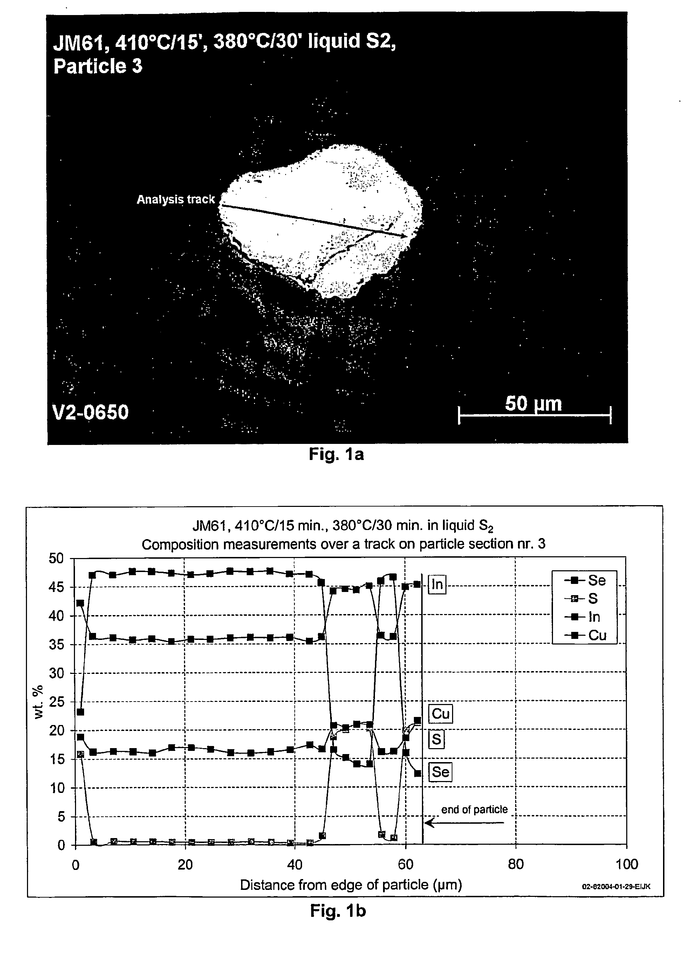

Fig. 1a zeigt die lichtmikroskopische Aufnahme eines solchen Pulverkorns, das während 15 Minuten bei 410°C ("410°C, 15' ") und nachfolgend während 30 Minuten bei 380°C ("380°C, 30' '')in flüssigem S₂ "gekocht" wurde. In die Figur ist ebenfalls ein Analysepfad ("analysis track") eingezeichnet.

Entlang dieses Analysepfades wurde die chemische Zusammensetzung untersucht. Die Ergebnisse dieser Untersuchung sind in der Figur 1b anhand einer Grafik gezeigt. Die waagerechte Achse gibt dabei die Entfernung von der Kante des Pulverkorns an, bei der eine Analyse vorgenommen wird und die vertikale Achse gibt den prozentualen Anteil am Gewicht (wt. %) an, mit dem ein Element an der entsprechenden Stelle des Pulverkorns vorhanden ist.

In der Figur 1b ist erkennbar, dass die chemische Zusammensetzung des Pulverkorns bis zu einem Abstand von etwa 55 µm von der Kante des Pulverkorns in etwa der Zusammensetzung von stöchiometrischem CuInSe₂ entspricht. Diese weist ca. 18.8 wt.% Cu, ca. 34.2 wt.% In und ca. 47 wt.% Se auf. Schwefel ist kaum vorhanden.

Es ist in Figur 1b ferner erkennbar, dass ab einem Abstand von ca. 55 µm von der Kante des Pulverkorns bis zu einem Abstand von etwa 70 µm insbesondere der Se-Gehalt stark abnimmt und wieder ansteigt und der S- Gehalt ansteigt und wieder abnimmt.

Dieser Umstand nährt die bereits formulierte Vermutung, dass an dieser Stelle auf dem Analysepfad, die in der Aufnahme von Figur 1a dunkel erscheint, eine CuInSe₂- Verbindung mit einem unterstöchiometrischen Anteil an Se vorliegt, und dass hier während der Behandlung des Pulverkorns entsprechend dem erfindungsgemäßen Verfahren der im Sinne der Stöchiometrie überschüssige Anteil an Cu und In mit dem Schwefel in CuInS₂ umgesetzt wurde. An den im Analysepfad vorangehenden Stellen hat eine derartige Umsetzung offenbar nicht stattgefunden.

Es kann geschlossen werden, dass an den Stellen, an denen vor der Behandlung der Körner ein unterstöchimetrischer Anteil an Se vorgelegen hat, nach der Behandlung entsprechend dem erfindungsgemäßen Verfahren sowohl CuInSe₂ in nahezu stöchiometrischer Zusammensetzung als auch CuInS₂ vorliegt.

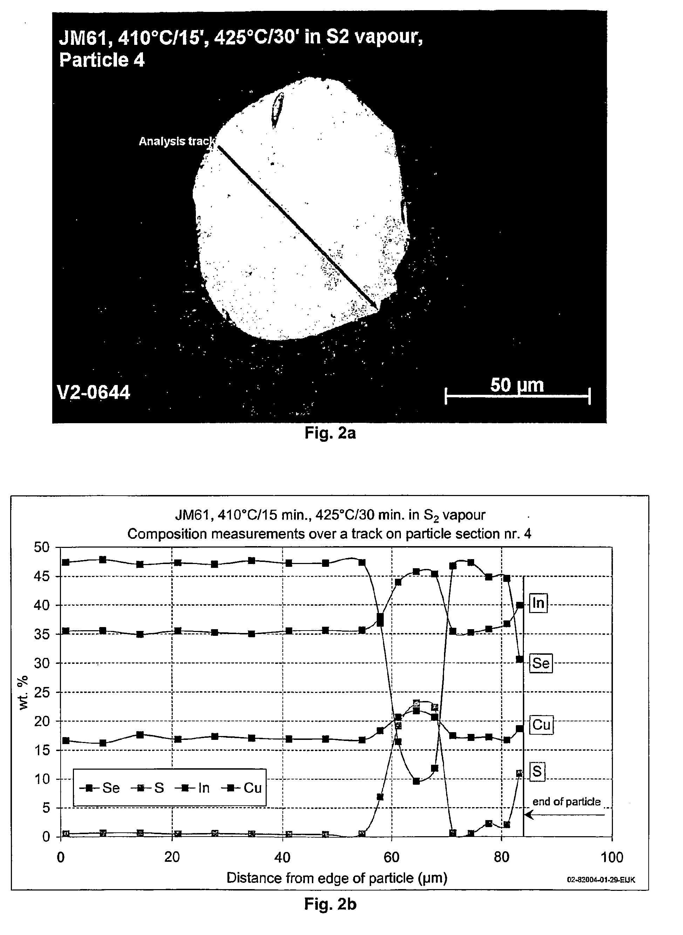

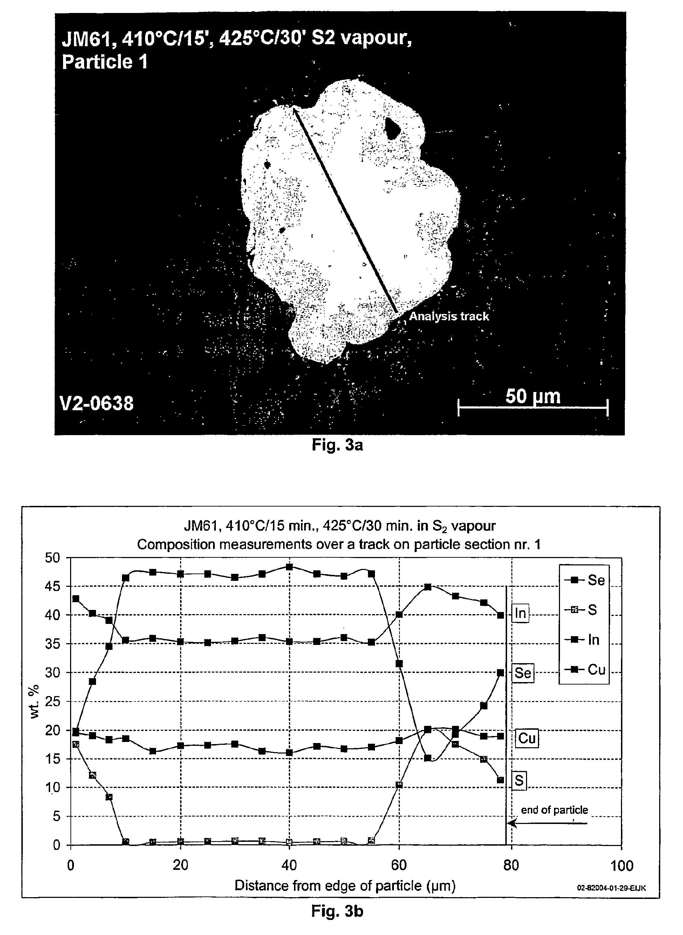

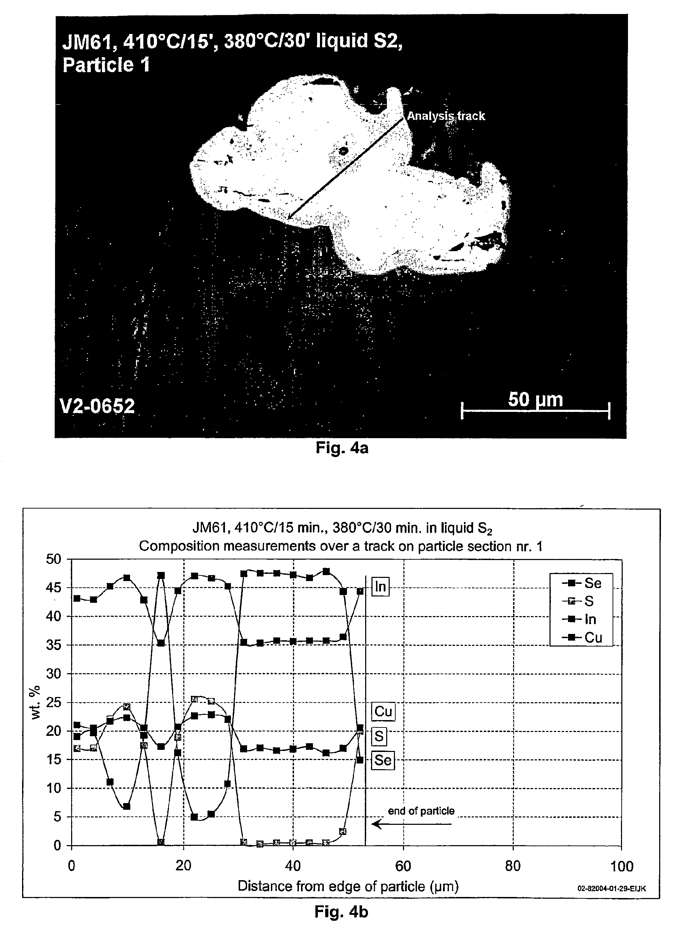

Den Figuren 2a bis 4b sind ähnliche Ergebnisse für andere Pulverkörner zu entnehmen. Den Figuren ist jeweils zu entnehmen bei welcher Temperatur und während welchen Zeitraums die Pulverkörner behandelt wurden. Es ist ebenfalls aufgeführt, ob die Pulverkörner in flüssigem Schwefel "gekocht" wurden ("liquid S2") oder ob die Körner in der Zwei-Zonen- Ampulle mit gasförmigem Schwefel ("S2 vapour") behandelt wurden.

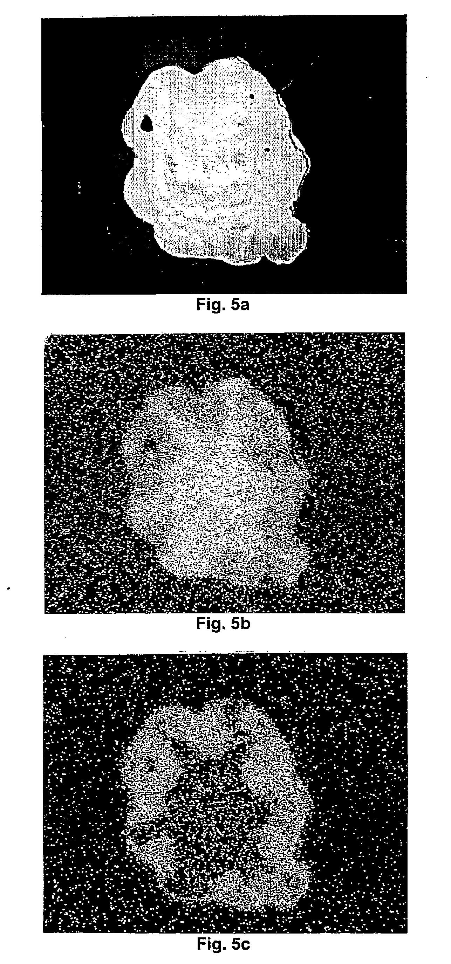

Die Figur 5b zeigt das Resultat eines mit dem Verfahren der Rückstreuelektronenaufnahme analysierten Se-Gehalts des in der ebenfalls elektronenmikroskopischen Aufnahme in der Figur 5a gezeigten Pulverkorns. Die hellen Bereiche in der Figur 5b mit einer hohen Dichte von weißen Punkten entsprechen dabei den Bereichen mit einem hohen Se-Gehalt, die dunklen Bereiche entsprechen Stellen mit einem niedrigen Se-Gehalt.

Die Figur 5c zeigt das Resultat einer auf den S- Gehalt sensitiven Rückstreuelektronenaufnahme des in der Aufnahme in der Figur 5a gezeigten Pulverkorns. Die hellen Bereiche in der Figur 5c entsprechen dabei Bereichen mit einem hohen S-Gehalt, die dunklen Bereiche entsprechen Stellen mit einem niedrigen S-Gehalt.

Ein Vergleich der Figuren 5b und 5c zeigt, dass Bereiche mit einem niedrigen Se-Gehalt den Bereichen mit einem hohen S-Gehalt entsprechen.

Dieser Umstand stützt ebenfalls die Hypothese, die zur Erklärung der Ergebnisse in den Figuren 1a bis 4b herangezogen wurde.

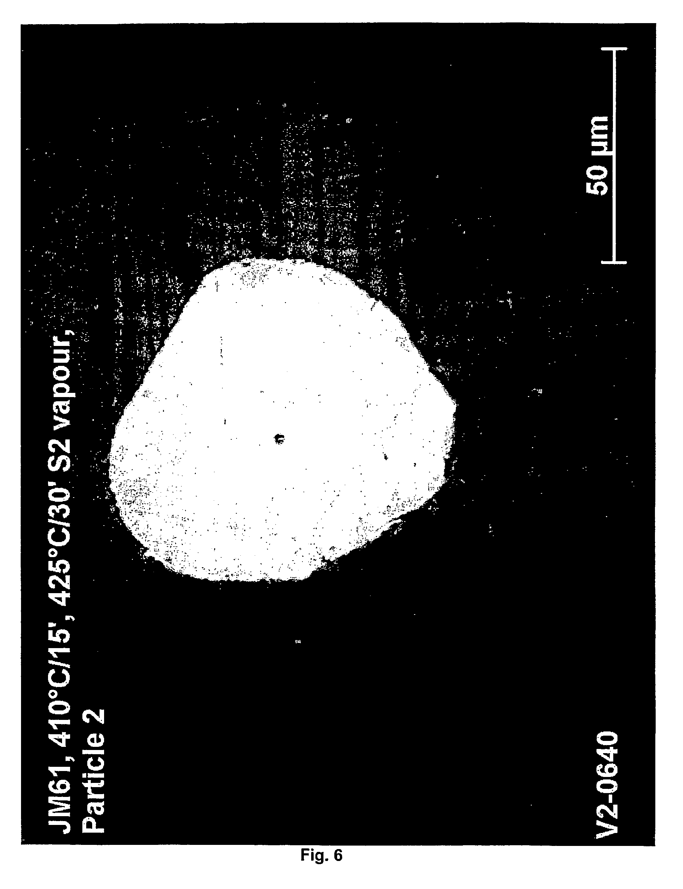

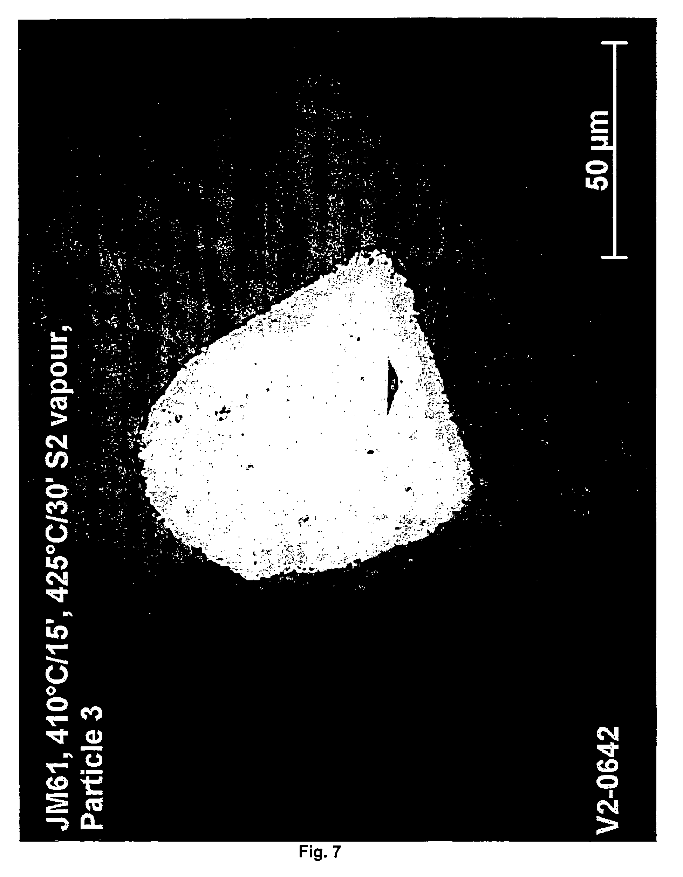

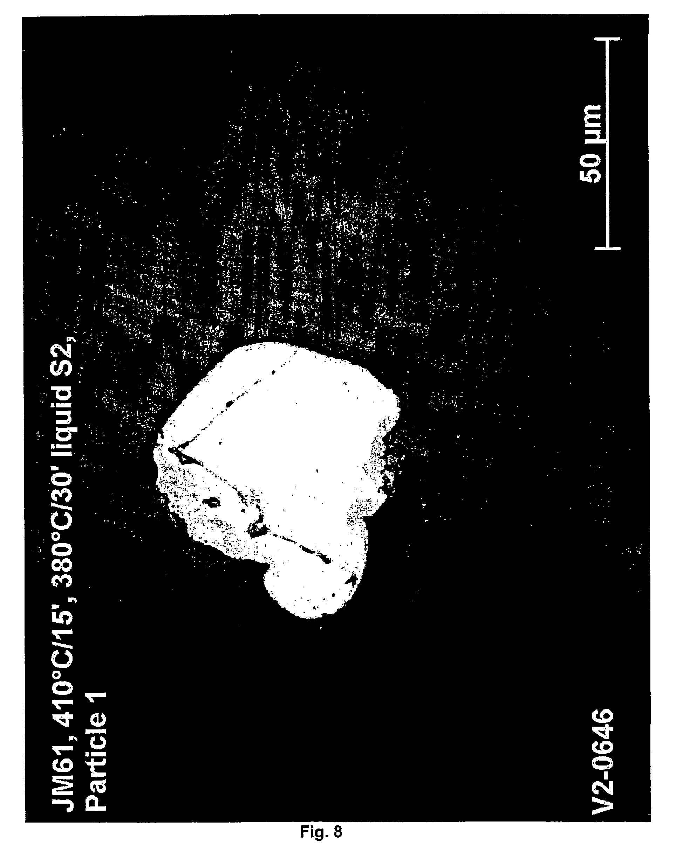

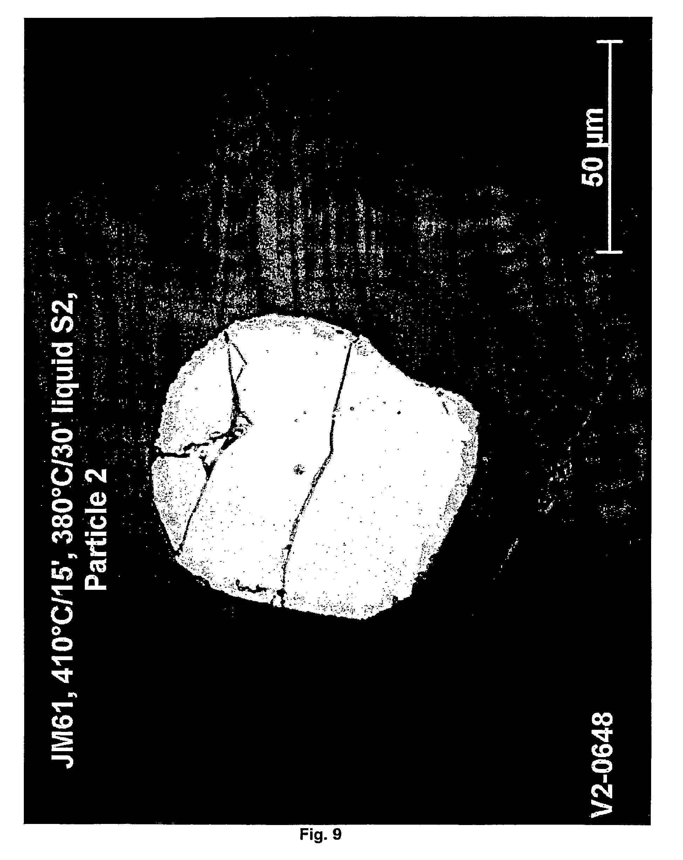

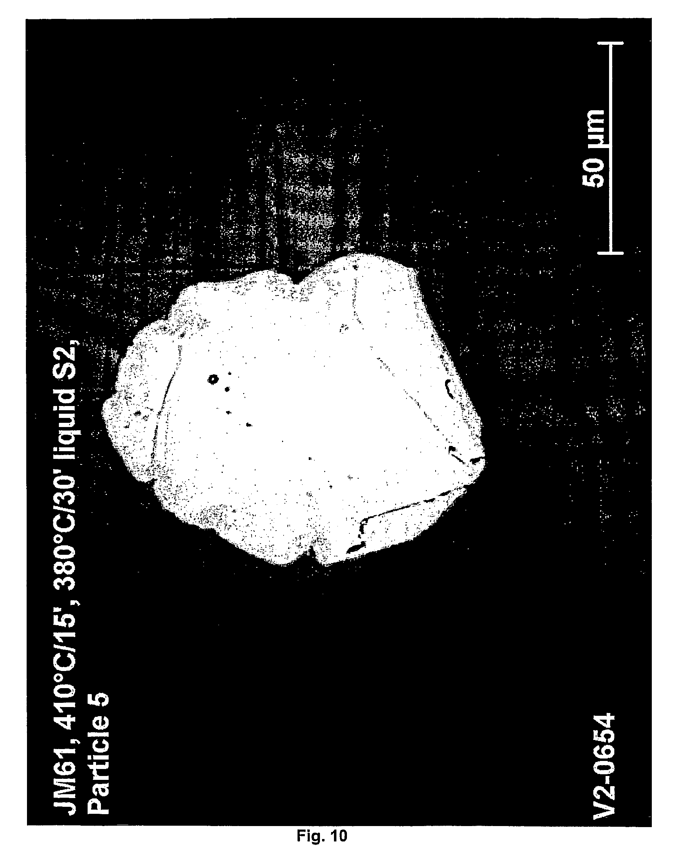

Die Figuren 6 bis 10 zeigen weitere lichtmikroskopische Aufnahmen von polierten Pulverkörnern.

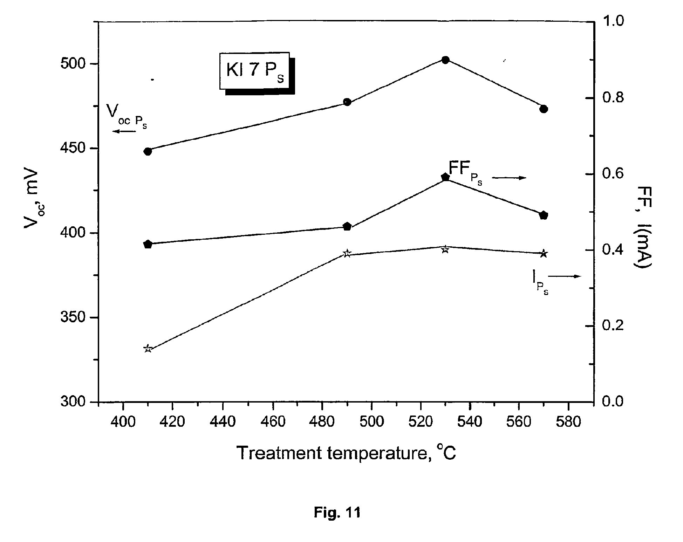

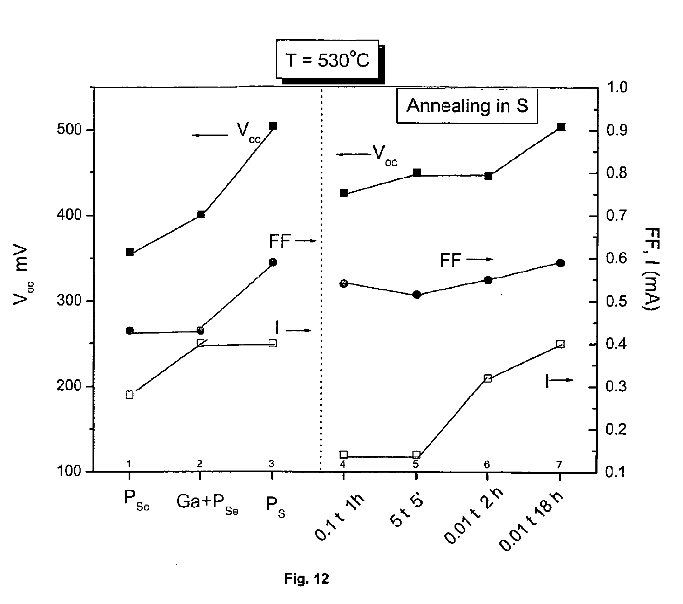

In den Figuren 11 und 12 sind die Kenngrößen von Solarzellen in denen die erfindungsgemäß behandelten Körner verwendet wurden in Abhängigkeit verschiedener Parameter der Behandlung angegeben.

Die Solarzellen bestehen vorzugsweise aus einem Rückkontakt, einer Monokornmembran, mindestens einer Halbleiterschicht und einem Frontkontakt.

Zur Herstellung der Solarzellen werden die Körner dabei zunächst in eine vorzugsweise als Polymermembran ausgebildete Monokornmembran eingebettet, die auf den Rückkontakt der Solarzelle aufgebracht wurde.

Der Rückkontakt besteht dabei aus einem auf ein Glassubstrat aufgetragenen elektrisch leitfähigen Klebstoff.

Auf die aus den in die Polymermembran eingebetteten Körnern bestehende Monokornmembran wird mindestes eine weitere Halbleiterschicht aufgebracht. Es handelt sich dabei vorzugsweise um eine CdS- Bufferschicht und eine aus intrinsischem ZnO bestehende Schicht.

Auf diese wird schließlich und eine Schicht aus einer elektrisch leitfähigem ZnO:Al-Legierung aufgebracht. Die letztgenannte Schicht dient dabei als Frontkontakt der Solarzelle.

Figur 11 zeigt die Leerlaufspannung V_{OC}, den Füllfaktor FF und den Kurzschlussstrom I einer die erfindungsgemäß behandelten Körner enthaltenden Solarzelle in Abhängigkeit der Behandlungstemperatur (Treatment temperature). Der Index P_{S} deutet dabei an, dass die Körner einer erfindungsgemäßen Schwefelung unterzogen wurden.

Die in Figur 11 gezeigten Ergebnisse beziehen sich dabei auf eine in einer Zwei- Zonen- Ampulle bei einer bestimmten, festen Temperatur des Schwefels durchgeführte Schwefelung.

Die in die Solarzelle eingestrahlte Leistung wurde während der Messreihe ebenfalls auf einen bestimmten, festen Wert eingestellt. Ausgefüllte Rechtecke, Kreise und nichtausgefüllte Rechtecke bezeichnen dabei, wie auch in der Figur 12, tatsächliche Messpunkte.

Die gezeigten Messergebnisse und insbesondere die Kurve, welche die Abhängigkeit der Leerlaufspannung V_{OC} angibt, bestätigen dabei die vorangehend aufgestellte Behauptung, dass besonders gute Ergebnisse im Hinblick auf eine Verbesserung der photovoltaischen Eigenschaften der Pulverkörner durch eine Behandlung erzielt werden konnten, bei der die Pulverkörner auf eine Temperatur von 530°C erhitzt wurden.

Figur 12 zeigt die Abhängigkeit der Kenngrößen von den anderen Parametern der Behandlung. Die Ergebnisse beziehen sich dabei ebenfalls auch die Behandlung in der Zwei- Zonen-Ampulle und wurden für Pulverkörner aufgenommen, die für die Behandlung auf eine Temperatur von 530°C erhitzt wurde.

Neben der erfindungsgemäßen Schwefelung wurden auch andere Methoden zur Behandlung der Pulverkörner getestet. Die Ergebnisse für diese alternativen Methoden sind auf der linken Seite der Figur 12 gezeigt.

Die Körner wurden dabei der erfindungsgemäßen Behandlung mit Schwefel unterzogen (P_{S}), sowie einer analogen Behandlung in der Schwefel durch Selen ersetzt wurde (P_{Se}). Zudem wurde die Behandlung mit Selen auch für Pulverkörner durchgeführt, die nicht aus einer reinen CuInSe₂- Verbindung bestanden, sondern eine Beimischung von Ga enthielten (Ga+P_{Se}). Entsprechend der Interpretation der Erfolge der erfindungsgemäßen Schwefelung erwartet man bei den beiden letztgenannten Behandlungsverfahren eine Umsetzung der Fremdphasen in Cu(In,Ga)Se₂.

Die in Figur 12 dargestellte Abhängigkeit der Leerlaufspannung V_{OC}, des Füllfaktors FF und des Kurzschlussstroms I von der Behandlungsmethode zeigt, dass die erfindungsgemäße Behandlung die besten Eigenschaften für die Körner erbringt.

Die Umsetzung der Fremdphasen in Cu(In,Ga)S₂ scheint demnach wesentlich besser zu funktionieren als die Umsetzung der Fremdphasen in Cu(In,Ga)Se₂.

Die rechte Seite des Diagramms in Figur 12 zeigt die Abhängigkeit der Kenngrößen für eine Schwefelung (Annealing in S) von der Dauer der Behandlung und dem in der die Pulverkörner enthaltenden Zone der Zwei-Zonen-Ampulle eingestellten Schwefeldampfdruck. Die Temperatur in der die Körner enthaltenden Zone betrug dabei 530°C und der Schwefeldampfdruck wurde ausschließlich durch eine Veränderung der in der den Schwefel enthaltenden Zone herrschenden Temperatur variiert.

Wie auch für die Messung deren Ergebnisse im linken Teil der Figur 12 veranschaulicht sind, wurde die in die Solarzelle eingestrahlte Leistung für die Messungen auf einem konstanten Wert gehalten.

Die Messpunkte beziehen sich dabei auf Messungen an Solarzellen in den Pulverkörner verwendet wurde die einer Behandlung 1 Stunde (1h), 5 Minuten (5'), 2 Stunden (2h) und 18 Stunden (18h) mit einem Schwefeldampfdruck von 13.33 Pa (0,1 t), 666,5 Pa (5 t) und 1,33 Pa (0,01 t) unterzogen wurden.

Die Ergebnisse und insbesondere die Kurve für die Leerlaufspannung V_{oc} bestätigen dabei die vorangehend aufgestellte Behauptung, dass besonders gute Ergebnisse im Hinblick auf eine Verbesserung der photovoltaischen Eigenschaften der Pulverkörner durch eine Behandlung erzielt werden konnten, bei der der Schwefeldampfdruck 1,33 Pa und die Behandlungszeit 18 h betrugen.

Bislang wurde in der Beschreibung ausschließlich auf die Behandlung der Pulverkörner eingegangen. Im Folgenden soll daher ein besonders bevorzugtes Verfahren zur Herstellung der aus einer Cu(In,Ga)Se₂-Verbindung bestehenden Pulverkörner angegeben werden:

Zunächst werden bei diesem bevorzugten Verfahren Cu und In und/oder Cu und Ga legiert, wobei die eingesetzten Molmengen an Cu einerseits und In und Ga andererseits so bemessen werden, dass Cu-arme CuIn und CuGa-Legierungen entstehen. Es hat sich dabei als besonders vorteilhaft für die Herstellung von in Solarzellen eingesetzten Pulverkörnern ergeben, dass das Cu/(In+Ga)-Verhältnis, also das Verhältnis der eingesetzten Molmenge an Cu zu der Summe der eingesetzten Molmenge an In und der eingesetzten Molmenge an Ga, zwischen 1 und 1:1,2 liegt.

Das Verhältnis der eingesetzten Molmenge an Ga zu der eingesetzten Molmenge an In liegt vorzugsweise zwischen 0 und 0,43. Ein Verhältnis von 0,43 entspricht dabei etwa einem Ga-Anteil von 30% bezogen auf die Molmenge an In und Ga. Es werden mit dem Verfahren also vorzugsweise solche Cu(In,Ga)Se₂- Verbindungen hergestellt, die in ihrem Molverhältnis zwischen Ga und In zwischen diesem Molverhältnis der Verbindungen CuInSe₂ und CuGa_{0,3}In_{0,7}Se₂ liegen.

Die Legierungen werden dann zu einem Pulver zermahlen, wobei sich herausgestellt hat, dass die Korngrößen der herzustellenden Cu(In,Ga)Se₂-Pulverkörner von den Korngrößen des aus der CuIn- und/oder CuGa-Legierung hergestellten Pulvers abhängen. Es werden also gezielt Pulver mit einer bestimmten Größe der enthaltenen Körner gemahlen.

Das aus den Legierungen CuIn und CuGa bestehende Pulver wird nun in eine Ampulle gefüllt, die aus einem Material besteht, das mit keinem der hineinzugebenden Stoffe reagiert. Es besteht somit beispielsweise aus Quarzglas.

Zu dem Pulver wird Se in einer Menge hinzugegeben, die dem stöchiometrischen Anteil dieses Elementes an der herzustellenden Cu(In,Ga)Se₂-Verbindung entspricht.

Ferner wird entweder KI oder NaI als Flussmittel hinzugegeben, wobei der Anteil des Flussmittels an der später entstehenden Schmelze typischerweise etwa 40 Vol.-% beträgt. Im Allgemeinen kann der Anteil des Flussmittels an der Schmelze jedoch zwischen 10 und 90 Vol.-% liegen.

Die Ampulle wird nun evakuiert und mit dem angegebenen Inhalt auf eine Temperatur zwischen 650°C und 810°C erwärmt. Während des Erwärmens bildet sich Cu(In,Ga)Se₂.

Ist eine Temperatur innerhalb des genannten Temperaturbereichs erreicht, kommt es zur Rekristallisation von Cu(In,Ga)Se2 und gleichzeitig zu Kornwachstum.

Das Flussmittel ist bei dieser Temperatur geschmolzen, so dass der Raum zwischen den Körnern mit einer flüssigen Phase gefüllt ist, die als Transportmedium dient.

Die Schmelze wird während einer gewissen Haltezeit konstant auf der vorher eingestellten Temperatur gehalten. Je nach gewünschter Korngröße kann eine Haltezeit zwischen 5 Minuten und 100 Stunden erforderlich sein. Typischerweise beträgt sie etwa 30 Stunden.

Das Kornwachstum wird durch ein Abkühlen der Schmelze unterbrochen. Es ist dabei sehr vorteilhaft, die Schmelze sehr schnell, beispielsweise innerhalb weniger Sekunden, abzuschrecken.

Dieses so genannte "Quenchen" scheint notwendig zu sein, damit evtl. entstandene binäre CuSe-Phasen im Flussmittel verbleiben.

Bei einem langsamen Abkühlen besteht vermutlich die Gefahr, dass sich die metallischen CuSe-Phasen auf den Cu(In,Ga)Se₂-Kristallen ablagern und die Eigenschaften des hergestellten Pulvers im Hinblick auf einen Einsatz in Solarzellen erheblich beeinträchtigen.

In einem letzten Schritt des Verfahrens wird das Flussmittel durch ein Auslösen mit Wasser entfernt. Die einkristallinen Pulverkörner können der Ampulle dann entnommen werden.

Der geeignete zeitliche Temperaturverlauf beim Erwärmen und Abkühlen sowie die Haltezeit und die während der Haltezeit einzuhaltende Temperatur werden in Vorversuchen ermittelt.

Mit Hilfe des dargestellten Verfahrens lassen sich Pulver mit einem mittleren Durchmesser der einzelnen Körner von 0,1 µm bis 0,1 mm herstellen. Die Korngrößenverteilung innerhalb des Pulvers entspricht dabei einer Gauß-Verteilung der Form D=A·t^{1/n}·exp(-E/kT), wobei D der Korndurchmesser, t die Haltezeit und T die Temperatur der Schmelze ist; k bezeichnet wie üblich die Boltzmann-Konstante. Die Parameter A, n und E hängen von den eingesetzten Ausgangsstoffen, dem Flussmittel und den speziellen und hier nicht näher beschriebenen Wachstumsprozessen ab. Wird KI als Flussmittel eingesetzt, so ist etwa E = 0,25 eV. Der Wert für n liegt in diesem Falle zwischen 3 und 4.

Die mittlere Korngröße und die genaue Gestalt der Korngrößenverteilung hängen von der Haltezeit, der Temperatur der Schmelze und der Korngröße des eingesetzten aus den CuIn- und CuGa-Legierungen bestehenden Pulvers ab. Darüber hinaus werden mittlere Korngröße und Korngrößenverteilung von der Wahl des Flussmittels beeinflusst.

Die mit dem Verfahren herstellbaren Körner sind p-leitend und weisen eine sehr gute elektrische Leitfähigkeit auf. Die elektrischen Widerstände der hergestellten Cu(In,Ga)Se₂-Pulverkörner lagen je nach Wahl des Cu/Ga-Verhältnisses, das Cu/(In+Ga)-Verhältnisses und der Temperatur der Schmelze in einem Bereich von 100 Ω bis 10 kΩ. Dies entspricht einem spezifischen Widerstand von 10 kΩcm bis 2 MΩcm.

Mit Hilfe des Verfahrens konnten einkristalline Pulver produziert werden, deren Körner eine sehr gleichmäßige Zusammensetzung aufwiesen.

Die Pulver eignen sich besonders zur Herstellung von Monokornmembranen, die in Solarzellen Verwendung finden, wobei mit den anhand des Verfahrens hergestellten und gemäß dem erfindungsgemäßen Verfahren behandelten Pulvern Solarzellen mit einem sehr hohen Wirkungsgrad produziert werden konnten.

Das dargestellte Herstellungsverfahren scheint dabei den besonderen Vorteil aufzuweisen, dass sich aufgrund der Zugabe einer bezüglich der herzustellenden Verbindung unterstöchiometrischen Menge an Cu hauptsächlich Cu-arme Pulverkörner ausbilden. Damit wird das Problem vermieden, dass es in den Körnern zu einer Phasensegregation in stöchiometrisches CuInSe₂ und eine metallische CuSe-Binärphase kommt. Diese Fremdphase sammelt sich nämlich bevorzugt an der Oberfläche der Körner und kann Kurschlüsse in der Solarzelle herbeiführen.

Ferner hat das beschriebene Herstellungsverfahren offenbar den Vorteil, dass die bei der Herstellung der Körner entstehende CuSe-Phase in dem Flussmittel verbleibt und sich nicht an den Körnern anlagert.

Vor allem im Hinblick auf mögliche Einsatzzwecke des mit dem Verfahren hergestellten Pulvers wird zudem darauf hingewiesen, dass es prinzipiell auch möglich ist, S zusätzlich zum Se zu dem aus den CuIn und/oder CuGa bestehenden Pulver hinzuzugeben und mit dem Flussmittel aufzuschmelzen. Ebenso kann Se vollständig durch S ersetzt werden.

Das Verfahren ermöglicht damit die Herstellung einer großen Bandbreite von CuIn₁₋ₓGaₓS_{y}Se_{z}-Verbindungen. Diese Halbleiterverbindungen decken einen Bereich von Bandlückenenergien zwischen 1,04 eV und 2,5 eV ab.

Somit lassen sich mit den beschriebenen Herstellungsverfahren bereits Pulverkörner herstellen, die sehr gute photovoltaische Eigenschaften aufweisen, die durch die erfindungsgemäße Schwefelbehandlung noch weiter verbessert werden können. Die Pulverkörner eignen sich insbesondere für den Einsatz in einer Solarzelle.

## Patentansprüche

1. Verfahren zur Behandlung von aus einer Cu(In,Ga)Se₂-Verbindung bestehenden Pulverkörnern,
**dadurch gekennzeichnet,**
**dass** die Pulverkörner und eine Menge Schwefel in ein Gefäß hineingegeben werden und der aus den Körnern und dem Schwefel bestehende Inhalt des Gefäßes erhitzt wird und über einen Zeitraum auf einer konstanten Temperatur gehalten wird.

2. Verfahren nach Anspruch 1,
**dadurch gekennzeichnet,**
**dass** die Körner und Schwefel in eine Zwei-Zonen-Ampulle gefüllt werden, wobei die Körner in eine der Zonen und die Menge Schwefel in die andere Zone hineingegeben werden.

3. Verfahren nach einem oder beiden der Ansprüche 1 und 2,
**dadurch gekennzeichnet,**
**dass** die Körner auf eine Temperatur zwischen 400°C und 600°C erhitzt werden.

4. Verfahren nach einem oder mehreren der vorangegangenen Ansprüche,
**dadurch gekennzeichnet,**
**dass** der Schwefel auf eine Temperatur von etwa 100°C erhitzt wird.

5. Verfahren nach einem oder mehreren der vorangegangenen Ansprüche,
**dadurch gekennzeichnet,**
**dass** die Körner und der Schwefel über einen Zeitraum zwischen einer Stunde und 50 Stunden jeweils auf einer konstanten Temperatur gehalten werden.

6. Verfahren nach Anspruch 1,
**dadurch gekennzeichnet,**
**dass** ein aus den Pulverkörnern und dem Schwefel bestehendes Gemisch in eine Ampulle gefüllt wird.

7. Verfahren nach einem oder beiden der Ansprüche 1 und 6,
**dadurch gekennzeichnet,**
**dass** das aus den Pulverkörnern und dem Schwefel bestehende Gemisch auf eine Temperatur zwischen 300°C und 600°C erhitzt wird.

8. Verfahren nach einem oder mehreren der Ansprüche 1, 6 und 7,
**dadurch gekennzeichnet,**
**dass** das Gemisch aus Pulverkörnern und Schwefel über einen Zeitraum zwischen 5 Minuten und 4 Stunden auf einer Temperatur gehalten wird.

9. Monokornmembran-Solarzelle, beinhaltend einen Rückkontakt, eine Monokornmembran, mindestes eine Halbleiterschicht und einen Frontkontakt,
**dadurch gekennzeichnet,**
**dass** die Monokornmembran mit einem Verfahren nach einem oder mehreren der Ansprüche 1 bis 8 behandelte Pulverkörner enthält.

## Claims

1. A method for treating powder particles consisting of a Cu(In,Ga)Se₂ compound,
**characterized in that**
the powder particles and an amount of sulfur are placed into a vessel and the vessel contents consisting of the powder particles and the sulfur are heated up and kept at a constant temperature for a period of time.

2. The method according to Claim 1,
**characterized in that**
the particles and the sulfur are filled into a two-zone ampoule, whereby the powder particles are placed into one of the zones and the amount of sulfur is placed into the other zone.

3. The method according to one or both of Claims 1 and 2,
**characterized in that**
the particles are heated up to a temperature between 400°C and 600°C.

4. The method according to one or more of the preceding claims,
**characterized in that**
the sulfur is heated up to a temperature of about 100°C.

5. The method according to one or more of the preceding claims,
**characterized in that**
the particles and the sulfur are kept at a constant temperature for a period of time between one hour and 50 hours.

6. The method according to Claim 1,
**characterized in that**
a mixture consisting of the powder particles and the sulfur is filled into an ampoule.

7. The method according to one or both of Claims 1 and 7,
**characterized in that**
the mixture consisting of the powder particles and the sulfur is heated to a temperature between 300°C and 600°C.

8. The method according to one or more of Claims 1, 6 and 7,
**characterized in that**
the mixture consisting of powder particles and sulfur is kept at a given temperature for a period of time between 5 minutes and 4 hours.

9. A mono-particle membrane solar cell comprising a back contact, a mono-particle membrane, at least one semiconductor layer and a front contact,
**characterized in that**
the mono-particle membrane contains the powder particles treated according to one or more of Claims 1 to 8.

## Revendications

1. Procédé pour le traitement de grains de poudre se composant d'un composé Cu(In,Ga)Se₂,
**caractérisé en ce que**
les grains de poudre ainsi qu'une quantité de soufre sont introduits dans un récipient et **en ce que** le contenu du récipient se composant des grains et du soufre est chauffé et est maintenu à une température constante pendant une période de temps donnée.

2. Procédé selon la revendication 1,
**caractérisé en ce que**
les grains et le soufre sont versés dans une ampoule à deux zones, les grains étant introduits dans l'une des zones et la quantité de soufre dans l'autre zone.

3. Procédé selon l'une ou les deux revendications 1 et 2,
**caractérisé en ce que**
les grains sont chauffés à une température comprise entre 400 °C et 600 °C.

4. Procédé selon une ou plusieurs des revendications précédentes,
**caractérisé en ce que**
le soufre est chauffé à une température de l'ordre de 100 °C.

5. Procédé selon une ou plusieurs des revendications précédentes,
**caractérisé en ce que**
les grains et le soufre sont à chaque fois maintenus à température constante, pendant une période de temps comprise entre une heure et 50 heures.

6. Procédé selon la revendication 1,
**caractérisé en ce que**
un mélange se composant des grains de poudre et du soufre est versé dans une ampoule.

7. Procédé selon une ou les deux revendications 1 et 6,
**caractérisé en ce que**
le mélange se composant des grains de poudre et du soufre est chauffé et est maintenu à une température comprise entre 300 °C et 600 °C.

8. Procédé selon une ou plusieurs des revendications 1, 6 et 7
**caractérisé en ce que**
le mélange se composant de grains de poudre et de soufre est maintenu à une température donnée pendant une période de temps comprise entre 5 minutes et 4 heures.

9. Cellule solaire à membrane monogranulaire, comprenant un contact postérieur, une membrane monogranulaire, au moins une couche semiconductrice et un contact frontal,
**caractérisée en ce que**
la membrane monogranulaire contient des grains de poudre traités avec un procédé selon une ou plusieurs des revendications 1 à 8.
